# EUROPEAN PATENT APPLICATION

(11) **EP 2 007 176 A1**
(43) Date of publication of application: **24.12.2008**
(21) Application number: 07736883.5
(22) Date of filing: 14.03.2007
(51) Int. Cl.: H05K 1/14

(54) **CIRCUIT BOARD AND CONNECTION SUBSTRATE**

(30) Priority: 20.03.2006 JP 2006075896; 24.05.2006 JP 2006144444; 24.05.2006 JP 2006144453; 31.07.2006 JP 2006207426; 08.09.2006 JP 2006244292
(71) Applicant: Sumitomo Bakelite Company, Ltd., Tokyo 140-0002 (JP)
(72) Inventor: CHUMA, Toshiaki, c/o Akita Sumitomo Bake Co., Ltd., Akita-shi Akita 011-8510 (JP); INABA, Makoto, c/o Akita Sumitomo Bake Co., Ltd., Akita-shi Akita 011-8510 (JP)
(74) Representative: Müller, Christian Stefan Gerd
(86) International application number: PCT/JP2007/000226
(87) International publication number: WO 2007/108207

(57) **Abstract**

There is provided a circuit board including a first and a second circuit substrate located with a spacing, on which a first and a second conductor pad are provided respectively; and a connection substrate including a first and a second conductor post projecting from one or the other side; the connection substrate being disposed so as to cover a portion of the first and the second circuit substrate, and bridged therebetween; the first conductor post and the first conductor pad, as well as the second conductor post and the second conductor pad, being disposed so as to oppose each other; the circuit board also including a connector portion to be formed upon melting a metal coating layer, formed in advance on a surface of at least one of the first conductor post and the first conductor pad, and on a surface of at least one of the second conductor post and the second conductor pad; the first and the second circuit substrate and the connection substrate being electrically connected through the connector portion.

## Description

### [TECHNICAL FIELD]

The present invention relates to a circuit board and a connection substrate to be used as a component for an electronic apparatus.

### [BACKGROUND ART]

Recent progress in level of integration of electronic apparatuses has been promoting reduction in dimensions of circuit substrates incorporated therein. The requirement for higher density is also directed to the material of those substrates, and the purpose of use of such substrates is spreading. Also, for making the electronic apparatus smaller in dimensions and lighter in weight, a plurality of circuit substrates electrically connected to each other is densely arranged so as to increase the accommodation efficiency inside the apparatus.

Methods of thus electrically connect the circuit substrates include inserting the respective circuit substrates into a connector. For example, the connector is implemented in each circuit substrate, and the connection substrate is provided, on both end portions, a terminal portion that can be inserted into the connector, so that the electrical connection is achieved upon inserting the respective terminal portions into the connector mounted on each circuit substrate (for example, patent document 1).

The conventional art discloses the method of connecting two substrates in which the connector is employed, such that the contact between the inserted substrate and the conductor pattern of the connector is ensured. However, in case where the contact surface suffers a crack or the like, the assurance of the contact may be degraded. Also, the method of employing the connector so as to electrically connect the circuit substrates leads to an increase in number of parts to be implemented, which makes it difficult to reduce the dimensions and weight of the circuit substrate.

Meanwhile, further progress in micronization and level of integration of the electronic apparatuses has led to employment of another connection method, namely a multilayer substrate such as a rigid-flex circuit board. The rigid-flex circuit board integrally includes both of a rigid portion and a flexible portion. To form the flexible portion of the rigid-flex circuit board which includes the flexible portion, however, measures such as separately forming the flexible portion in advance have to be taken when executing the laminating process, which makes the process more complicated. Besides, referring to an interlayer adhesive employed for bonding the stacked layers, the flow of the adhesive has to be adjusted so as to control the exudation of the adhesive.

Further, in the field of recently developed mobile apparatuses, typically the mobile phone, the substrate is often provided in a module form so as to fulfill the high-level functions given, and a plurality of circuit substrates and a primary substrate have to be connected through a flexible circuit board according to those functions. The manufacturing methods include a build-up type process and simultaneous laminating process. However both of those methods require a long and complicated process. Besides, with reference to the rigid-flex circuit board, it takes a quite troublesome process to manufacture the substrates having different number of rigid portion layers at a time, which constitutes a factor that increases the product cost.
Regarding a folding type mobile phone as an example, in the case where a plurality of flexible portions is wound once at the hinge portion, the flexible portion located on the inner side is corrugated and rubbed if the flexible portions are of the same length, thereby incurring degradation in flexibility. Accordingly, in manufacturing the rigid-flex circuit board, the inner flexible portion of a different length is prepared so as to form the multilayered flex portion. By this method, however, the longer flexible portion incurs a slack portion, and hence a jig has to be employed so as to avoid the interference of the slack portion when forming the multilayered flex portion. Thus, the complicated manufacturing process of the rigid-flex circuit board is made even more complicated, which results in lowered yield and increased cost (for example, patent document 2).
[Patent document 1] JP-A No.2000-113933
[Patent document 2] JP-A No.2003-133734

### [DISCLOSURE OF THE INVENTION]

The present invention has been accomplished in view of the foregoing situation, and provides a circuit board to which a plurality of circuit substrates is electrically connected with a simple structure formed without undergoing a complicated process. The present invention also provides a circuit board to which the plurality of circuit substrates is connected without incurring an increase in number of implemented components.

The object of the present invention is achieved through the measures described hereunder.

According to the present invention, there is provided:
[1] A circuit board comprising a first and a second circuit substrate located with a spacing, on which a first and a second conductor pad are provided respectively; and a connection substrate including a first and a second conductor post projecting from one or the other side; the connection substrate being disposed so as to cover a portion of the first and the second circuit substrate, and bridged therebetween; the first conductor post and the first conductor pad, as well as the second conductor post and the second conductor pad, being disposed so as to oppose each other; the circuit board comprising a connector portion to be formed upon melting a metal coating layer, formed in advance on a surface of at least one of the first conductor post and the first conductor pad, and on a surface of at least one of the second conductor post and the second conductor pad; the first and the second circuit substrate and the connection substrate being electrically connected through the connector portion.
[2] The circuit board according to [1] above, wherein an end portion of the connection substrate is connected to a side of the first circuit substrate, and the other end portion is connected to the other side of the second circuit substrate.
[3] The circuit board according to [1] or [2] above, comprising a plurality of connection substrates including a flexible portion; and a region where the respective flexible portions overlap; wherein the flexible portions are different in length in the overlapping region.
[4] The circuit board according to any one of [1] to [3] above, wherein the first circuit substrate and the second circuit substrate are different in number of layers.
[5] A circuit board comprising a primary circuit substrate including a plurality of conductor pads; and
   a plurality of connection substrates including a conductor post projecting from one or the other side;
   the conductor pad and the conductor post being disposed so as to oppose each other at an end portion of the primary circuit substrate; the circuit board comprising a connector portion to be formed upon melting a metal coating layer formed in advance on a surface of at least one of the conductor post and the conductor pad; the primary circuit substrate and the plurality of connection substrates being electrically connected through the connector portion.
[6] The circuit board according to [5] above, further comprising at least a secondary circuit substrate including a conductor pad; the connection substrate having an end portion connected to an end portion of the primary circuit substrate, and including another conductor post on either side of the other end portion; the circuit board comprising a connector portion to be formed upon melting a metal coating layer formed in advance on a surface of at least one of the conductor pad and the another conductor post provided on the secondary circuit substrate; the secondary circuit substrate and the connection substrate being electrically connected through the connector portion.
[7] The circuit board according to [5] or [6] above, wherein the connector portion is provided on both sides of the primary circuit substrate.
[8] The circuit board according to [6] or [7] above, wherein the secondary circuit substrate includes one or more secondary substrates, and at least one of the secondary circuit substrates is different in number of layers from the primary circuit substrate.
[9] The circuit board according to any of [1] to [8] above, wherein the connection.substrate includes: a base material, a conductor circuit formed on either side of the base material, and a coating layer that covers the conductor circuit; a first and a second hole penetrating through at least one of the base material and the coating layer, so as to reach the conductor circuit; and a first and a second conductor post formed in the first and the second hole respectively; an end portion of the first and the second conductor post being connected to the conductor circuit, and the other end portion of the first and the second conductor post projecting from a surface of the base material or of the coating layer.
[10] The circuit board according to any one of [1] to [4] above, wherein a periphery of the first and the second conductor post is selectively covered with an interlayer adhesive, and the first and the second circuit substrate and the connection substrate are stacked and adhered by the interlayer adhesive through the metal coating layer.
[11] The circuit board according to any one of [5] to [9] above, wherein a periphery of the conductor post is selectively covered with the interlayer adhesive, and the primary circuit substrate and the connection substrate are stacked and adhered by the interlayer adhesive through the metal coating layer.
[12] The circuit board according to [11] above, wherein the interlayer adhesive is an adhesive having a flux effect.
[13] The circuit board according to any one of [1] to [12] above, wherein the connector portion constitutes a fillet.
[14] The circuit board according to any of [1] to [13] above, wherein the connection substrate is a flexible substrate.
[15] The circuit board according to any of [1] to [14] above, wherein a tip portion of a projecting portion of the conductor post includes an unflat portion.
[16] A connection substrate comprising: a base material, a conductor circuit formed on either side of the base material, and a coating layer that covers the conductor circuit; a first and a second hole penetrating through at least one of the base material and the coating layer so as to reach the conductor circuit; and a first and a second conductor post formed in the first and the second hole respectively; an end portion of the first and the second conductor post being connected to the conductor circuit, and the other end portion of the first and the second conductor post projecting from a surface of the base material or of the coating layer.
[17] The connection substrate according to [16] above, wherein one of the first and the second conductor post is formed in the hole penetrating through the base material so as to project from the surface of the base material, and the other conductor post is formed in the hole penetrating through the coating layer, so as to project from the surface of the coating layer.
[18] The connection substrate according to [16] or [17] above, wherein the connection substrate is flexible.
[19] The connection substrate according to any one of [16] to [18] above, wherein a tip portion of a projecting portion of the conductor post includes an unflat portion.
[20] The connection substrate according to any of [16] to [19] above, wherein the first and the second conductor post is covered with a metal coating layer.

The present invention provides a circuit board on which a plurality of circuit substrates is electrically connected, through a simplified process. The present invention also provides a connection substrate that contributes to reducing the dimensions and weight without significantly increasing the thickness, by directly connecting circuits through conductor posts. Employing such connection substrate allows making the circuit board smaller, without incurring an increase in number of components to be implemented. Further, the circuit substrates can be electrically connected without employing a connector, which enables obtaining a circuit board having high connection reliability, as well as reducing the dimensions and weight of the apparatus.

### [BRIEF DESCRIPTION OF THE DRAWINGS]

The above and other objects, features and advantages will become more apparent through the following preferred embodiments and the drawings accompanying therewith.

Fig. 1 is a plan view showing a circuit board according to a first embodiment;
Fig. 2 is a sequential cross-sectional view for explaining a method of manufacturing a connection substrate according to an embodiment of the present invention;
Fig. 3 is a sequential cross-sectional view for explaining the method of manufacturing the connection substrate according to the embodiment of the present invention;
Fig. 4 is a cross-sectional view showing a connection substrate according to a second embodiment;
Fig. 5 is a cross-sectional view showing a circuit board according to the second embodiment;
Figs. 6 are a plan view and a cross-sectional view respectively, showing a circuit board according to a third embodiment;
Fig. 7 is a schematic drawing showing the circuit boards helically wound;
Fig. 8 is a plan view showing a circuit board according to another embodiment of the present invention;
Figs. 9 are a plan view and a cross-sectional view respectively, showing a circuit board according to a fourth embodiment; and
Fig. 10 is a plan view showing a circuit board according to another embodiment of the present invention.

### [BEST MODE FOR CARRYING OUT THE INVENTION]

Hereunder, embodiments of the present invention will be described referring to the drawings. In all the drawings, same constituents will be given the same numerals, and detailed description thereof may not be given in the following passages.

### [First embodiment]

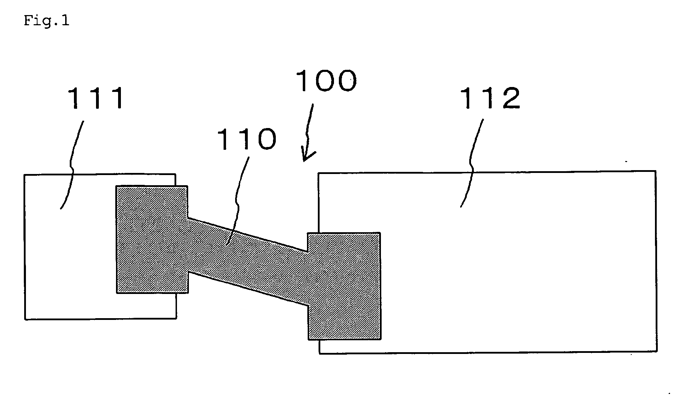

In this embodiment, a circuit board 100 as shown in Fig. 1 will be described, in which a first circuit substrate 111 and a second circuit substrate 112 are electrically connected through a connection substrate 110.

Fig. 3(c) is a cross-sectional view of the circuit board 100 shown in Fig. 1. The circuit board 100 includes a first and a second circuit substrate 111, 112 located with a spacing, on which a first and a second conductor pad 125, 135 are provided respectively, and a connection substrate 110 including a first and a second conductor post 155, 165 projecting from one or the other side. The connection substrate 110 is disposed so as to cover a portion of the first and the second circuit substrate 111, 112, and is bridged therebetween.
The first conductor post 155 and the first conductor pad 125, as well as the second conductor post 165 and the second conductor pad 135 are disposed so as to oppose each other. A metal coating layer 137 is formed in advance on a surface of at least one of the first conductor post 155 and the first conductor pad 125, and on a surface of at least one of the second conductor post 165 and the second conductor pad 135, and the circuit board 100 includes a connector portion that is formed upon melting the metal coating layer 137. The first and the second circuit substrate 111, 112 and the connection substrate 110 are electrically connected through the connector portion.

According to the present invention, the conductor post and the conductor pad are employed for connecting a plurality of circuit substrates, such that the substrates are bonded with a metal. Such structure eliminates the need to provide a connector, thereby preventing an increase in number of components. Also, melting by heat the vicinity of the connector portion between the circuit substrates and the connection substrate assures the electrical connection, which can be executed without employing a large-scaled equipment.

An example of a method of manufacturing the circuit board 100 according to this embodiment will now be described.

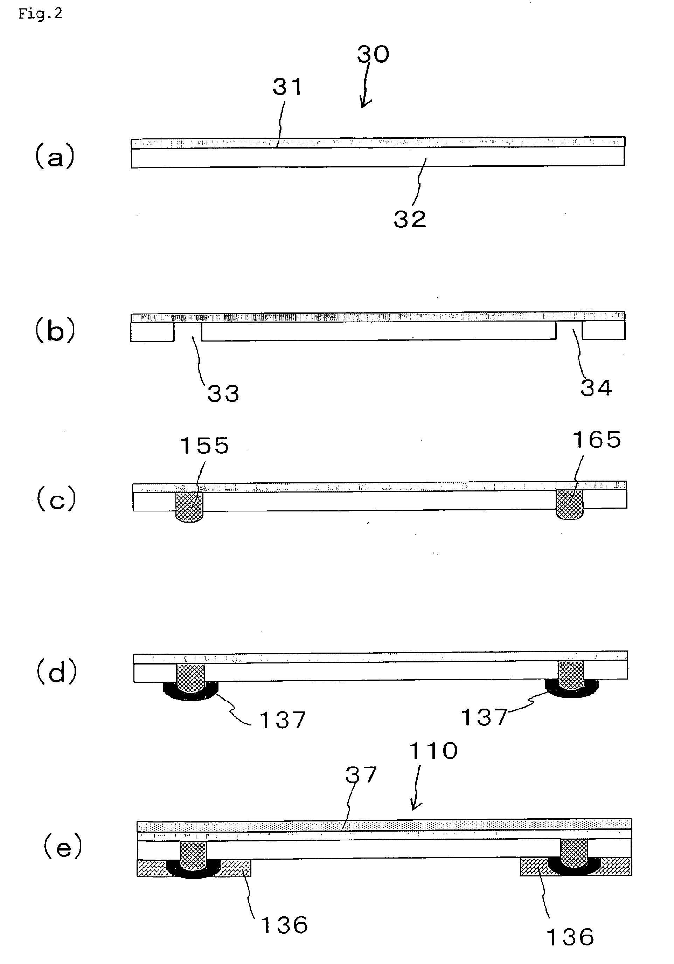

To start with, a manufacturing process of the connection substrate 110, which serves for electrically connecting the first circuit substrate 111 and the second circuit substrate 112, will be described (Figs. 2(a) to 2(e)). A first step is preparing a circuit substrate 30 including a base material 32 and a conductor circuit 31 provided on either side of the base material 32 (Fig. 2(a)).

The conductor circuit 31 is obtained through, for example, forming a metal foil on a surface of the base material 32 and executing an etching process. The metal foil can be exemplified by iron, aluminum, stainless steel, and copper. Among those, copper is preferable because of its excellent electrical characteristic. Although the thickness of the conductor circuit 31 is not specifically limited, a preferable range is equal to or more than 5 µm and equal to or less than 50 µm, and more preferably equal to or more than 9 µm and equal to or less than 35 µm. The thickness in the foregoing range assures, in particular, proper formation of the circuit through the etching process. Such thickness range also provides better handling performance of the base material after the formation of the conductor circuit.

Also, it is preferable that an adhesive layer for bonding the metal foil and the base material 32 is absent therebetween, from the viewpoint of prevention of emergence of smear which disturbs the conductor connection, and improvement in heat resistance. Nevertheless, the metal foil and the base material 32 may be joined with an adhesive.

An opening is then formed through the base material 32 from the surface thereof, such that the conductor circuit 31 is exposed. This leads to formation of a first and a second hole 33, 34 penetrating through the base material 32 and reaching the conductor circuit 31, as shown in Fig. 2(b).

In this case, employing a laser process allows easily forming the opening, and also forming a small-diameter via. Also it is preferable to perform a wet desmear process utilizing potassium permanganate aqueous solution, or a dry desmear process utilizing plasma, to thereby remove residual resin in the first and the second hole 33, 34. Removing the residual resin results in upgraded reliability of the interlayer connection.

Then the first and the second conductor post 155, 165 are formed in the first and the second hole 33, 34 respectively, so as to project from the surface of the base material 32 (Fig. 2(c)). Forming thus the first and the second conductor post 155, 165 in the first and the second hole 33, 34 causes an end portion of the first and the second conductor post 155, 165 to be connected to the conductor circuit 31, and the other end portion to project from the surface of the base material 32. The conductor post is formed, for example, through pasting or plating a conductor film. Although the height of the first and the second conductor post 155, 165 is not specifically limited, it is preferable that the height from the base material surface is equal to or more than 2 µm and equal to or less than 30 µm, and more preferably equal to or more than 5 µm and equal to or less than 15 µm. The height in such range provides excellent connection stability of the conductor post and the conductor pad. The tip portion of the projecting portion of the conductor post is preferably not flat but, for example, roundish, of a dome shape, or semispherical. The projecting portion may be larger in diameter than the hole. Such configuration facilitates an interlayer adhesive, to be subsequently referred to, to immigrate to the periphery of the conductor post, thus to be removed. Removing the interlayer adhesive from the contact interface between the conductor post and the conductor pad assures the electrical connection between the first and the second circuit substrate and the connection substrate.

Then the first and the second conductor post 155, 165 are coated with an alloy or the like, to thereby form the metal coating layer 137 (Fig. 2(d)). However, the metal coating layer 137 may be formed on the surface of the first and the second conductor pad 125, 135 to be connected to the first and the second conductor post 155, 165.

The coating layer 37 is then formed, so as to cover the conductor circuit 31 (Fig. 2(e)). To form the coating layer 37, the conductor circuit 31 is coated with for example a solder resist or a cover lay film. Here, the first and the second conductor post 155, 165 may be formed on the base material 32 before forming the conductor circuit 31, after which the conductor circuit 31 and the coating layer 37 may be formed.

Then the interlayer adhesive 136 (adhesive with the flux effect) is formed on a region of the base material 32 where the first and the second conductor post 155, 165 are projecting (Fig. 2(e)). Preferably, the adhesive with the flux effect 136 is selectively formed over the first and the second conductor post 155, 165 and the vicinity thereof. As will be subsequently described, the adhesive with the flux effect 136 present at the contact interface between the conductor post and the conductor pad immigrates to be removed, when the conductor post and the conductor pad are joined.

The adhesive with the flux effect 136 may be formed on the first and the second conductor pad 125, 135. In this case, the first and the second conductor pad 125, 135 are prevented from oxidation. Methods of applying the adhesive with the flux effect 136 include a printing process to apply the adhesive to the base material 32, and process the adhesive into a predetermined size so as to form individual pieces of the adhesive, and to thereby laminate them over the base material 32.

The adhesive with the flux effect 136 is, upon being formed, processed into a desired shape, and at this stage the connection substrate 110 is obtained (Fig. 2(e)).

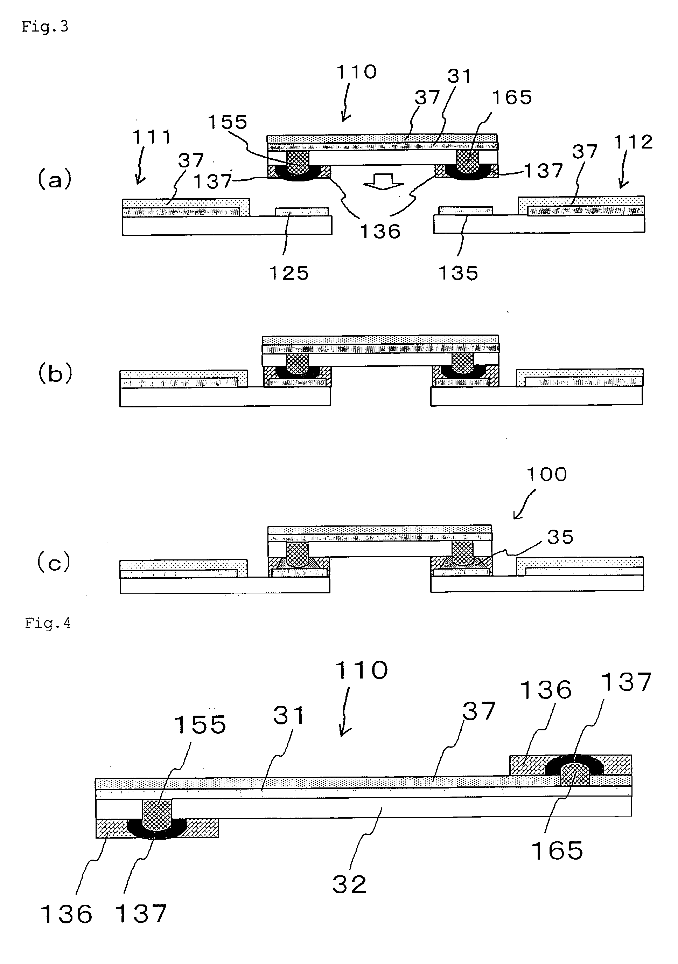

Now, a method of stacking the connection substrate 110 including the first and the second conductor post 155, 165 on the first circuit substrate 111 and the second circuit substrate 112 will be described (Figs. 3(a) to 3(c)).

The first circuit substrate 111 and the second circuit substrate 112 are free from specific limitations, except for respectively including the first and the second conductor pad 125, 135, to be joined with the first and the second conductor post 155, 165. The conductor pad may be constituted of a material similar to those cited with reference to the conductor circuit 31. In this embodiment, the first circuit substrate 111 and the second circuit substrate 112 are rigid circuit substrate. The first circuit substrate 111 and the second circuit substrate 112 may be the same or different in number of layers. Here, each layer includes, for example, a base material and a conductor circuit. Any of a one-sided circuit substrate (single layer), a double-sided circuit substrate (dual layer), and a multilayer circuit substrate may be employed as the first circuit substrate 111 and the second circuit substrate 112. Providing different number of layers better accomplishes the effect of the present invention, from the viewpoint of simplifying the manufacturing process.

As shown in Figs. 3(a) and 3(b), the connection substrate 110 is stacked on the first circuit substrate 111 and the second circuit substrate 112, such that the first conductor post 155 and the first conductor pad 125, as well as the second conductor post 165 and the second conductor pad 135 oppose each other.

The stacked structure is then subjected to a pressure equal to or more than 0.001 MPa and equal to or less than 3.0 MPa, and more preferably equal to or more than 0.01 MPa and equal to or less than 2.0MPa. The temperature during the pressurization is set such that the adhesive with the flux effect 136 is softened, and equal to or higher than the melting point of the metal coating layer 137. The pressurization is performed under such temperature range. Either only the region around the first and the second conductor post 155, 165, or the entire structure may be pressurized. As a result, the adhesive with the flux effect 136 is activated and thereby solder junction or metal junction is performed. On the connector portion, a solder fillet or a metal fillet 35 is formed because of the upgraded wettability of the metal surface (Fig. 3(c)).

Finally the structure is heated in an oven or a vacuum drier under a temperature range that causes the adhesive to cure but that keeps the metal coating layer 137 from melting again, to thereby cure the adhesive with the flux effect 136. As a result, the circuit board 100 shown in Fig. 3(c) is obtained. In this embodiment the presence of the connection substrate 110 allows obtaining the circuit board that enables reducing the size and increasing the level of integration, without the restriction on size and thickness.

The base material 32 employed in the connection substrate 110 according to this embodiment may be constituted of an insulating material formed by curing a resin such as a polyimide resin and an epoxy resin. Examples include a resin film such as a polyimide film, a polyetheretherketone film, a polyethersulfone film, and a liquid crystal polymer film, and a laminate such as an epoxy resin laminate, a phenol resin laminate, and a cyanate resin laminate. Among the foregoing, the resin film is preferable. Further, the polyimide film is preferable because of its excellent flexibility and heat resistance.

Although the thickness of the base material is not specifically limited, a preferable range is equal to or more than 9 µm and equal to or less than 50 µm, and more preferably equal to or more than 12 µm and equal to or less than 25 µm. The thickness in the foregoing range allows reducing the duration of the plating process for forming the conductor post.

It is preferable that the connection substrate 110 is a flexible substrate, and may be a printed circuit substrate including a flexible portion, for example.

The metal coating layer 137 is constituted, for example, of a metal or an alloy such as solder. It is preferable to employ a material that readily forms a fillet, to form the metal coating layer 137. The materials apt to form a fillet include those having a melting point lower than that of the material constituting the conductor post. Among those, the solder is preferably employed. The solder is composed of at least two selected from tin, lead, silver, zinc, bismuth, antimony, and copper. Such alloys include tin-lead based, tin-silver based, tin-zinc based, tin-bismuth based, tin-antimony based, tin-silver-bismuth based, and tin-copper based alloys, among which an optimal one may be selected without limitation to the combination or composition of the metals of the solder. A preferable thickness range of the metal coating layer 137 is equal to or more than 2 µm and equal to or less than 30 µm, and more preferably equal to or more than 3 µm and equal to or less than 20 µm, and still more preferably equal to or more than 5 µm and equal to or less than 20 µm. The thickness in the foregoing range leads to increased connection stability between the conductor post and the conductor pad, thereby upgrading the connection reliability.

In this embodiment, the first and the second circuit substrate 111, 112 and the connection substrate 110 are stacked and bonded through the metal coating layer 137, by means of the interlayer adhesive 136. Although the interlayer adhesive 136 is selectively formed so as to cover the conductor post and the vicinity thereof, the interlayer adhesive 136 present at the bonding interface is removed when the substrates are stacked and bonded. Thus, the conductor post and the conductor pad are joined by metal junction. However, the periphery of the conductor post and of the conductor pad is selectively covered with the interlayer adhesive 136 remaining unremoved. It is preferable to provide the interlayer adhesive so as to cover only the conductor post and the vicinity thereof, rather than the entire surface of the first and the second circuit substrate 111, 112. In the case where a flexible substrate is employed as the connection substrate 110, selectively covering only the conductor post and the vicinity thereof with the interlayer adhesive prevents degradation in flexibility of the connection substrate. In the region where the interlayer adhesive is not provided, the intrinsic flexibility of the flexible portion is maintained as it is.

It is preferable to employ, for example, an adhesive having a flux effect as the interlayer adhesive. The adhesive with the flux effect provides more reliable connection performance.

The adhesive with the flux effect means an adhesive capable of cleaning the surface of the metal, more specifically removing or reducing an oxide film present on the metal surface. Employing the adhesive with the flux effect enables performing the metal junction after removing, by activating the flux, the oxide film formed on the surface of the conductor post and the conductor pad. Accordingly, the metal junction of the conductor post and the conductor pad can be performed while cleaning the surface of the conductor post and conductor pad, which leads to the connection with a more reliable fillet. Thus, the adhesive with the flux effect 136 reduces the oxide film on the solder surface and on the copper foil which is the part to be connected, when melting the solder bump for achieving the interlayer electrical connection, thereby achieving desirable firm junction. Also, since the joint around the conductor post is covered with the interlayer adhesive, which serves to join the circuit substrate and the connection substrate in the stacked form, the circuit board attains higher reliability. Further, the adhesive employed in this embodiment does not have to be removed by cleaning or the like, after the soldering process. Accordingly, simply heating the resin as it is causes the resin to assume a three-dimensionally bridge structure to thereby achieve strong adhesion, and therefore such resin can be employed as an interlayer material for the circuit substrate and multilayer flexible printed circuit board.

Although the thickness of the interlayer adhesive 136 is not specifically limited, a preferable range is equal to or more than 8 µm and equal to or less than 30 µm, and more preferably equal to or more than 10 µm and equal to or less than 25 µm. The thickness in such range leads to excellent adhesion and suppression of exudation of the adhesive.

A first preferable composition of the adhesive with the flux effect is a combination of a resin (A) such as a phenol novolac resin including a phenolic hydroxyl group, a cresol novolac resin, an alkylphenol novolac resin, a resol resin, and a polyvinylphenol resin, and a curing agent (B) of the resin. Examples of the curing agent include an epoxy resin epoxidized from phenol bases such as a bisphenol base, a phenol novolac base, an alkylphenol novolac base, a biphenol base, a naphthol base, and a resorcinol base, and from a skeleton of an aliphatic, a cycloaliphatic or an unsaturated aliphatic product; and isocyanate compounds.

It is preferable to mix the resin including a phenolic hydroxyl group in a ratio of equal to or more than 20wt.% and equal to or less than 80wt.% with respect to the entirety of the adhesive. The content not less than 20wt.% secures sufficient cleaning performance of the metal surface, and the content not exceeding 80wt.% provides a sufficient curing effect. As a result, the adhesion strength and reliability can be desirably secured. On the other hand, a preferable mixing ratio of the resin which serves as the curing agent is equal to or more than 20wt.% and equal to or less than 80wt.%, with respect to the entirety of the adhesive. The adhesive may additionally contain a coloring agent, an inorganic filler, various coupling agents, a solvent, and so forth as the case may be.

A second preferable composition of the adhesive with the flux effect is a combination of an epoxy resin (C) epoxidized from phenol bases such as a bisphenol base, a phenol novolac base, an alkylphenol novolac base, a biphenol base, a naphthol base, and a resorcinol base, and from a skeleton of an aliphatic, a cycloaliphatic or an unsaturated aliphatic product; a curing agent (D) for the epoxy resin including an imidazole ring; and a curing type antioxidant (E). Examples of the curing agent including an imidazole ring include imidazole, 2-methylimidazole, 2-ethyl-4-methylimidazole, 2-phenylimidazole, 1-benzyl-2-methylimidazole, 2-undecylimidazole, 2-phenyl-4-methylimidazole, and bis(2-ethyl-4-methylimidazole). The curing type antioxidant is a compound that serves as an antioxidant and that can be cured through reaction with the curing agent, examples of which include a compound including a benzylidene structure, 3-hidorxy-2-naphthoic acid, pamoic acid, 2,4-dihydroxy benzoic acid, and 2,5-dihydroxy benzoic acid.

A preferable mixing ratio of the epoxy resin is equal to or more than 30wt.% and equal to or less than 99wt.%, with respect to the entirety of the adhesive. Such mixing ratio is preferable because a sufficient curing effect can be achieved.

Other than the foregoing two ingredients, a thermosetting resin such as a cyanate resin, an acrylic acid resin, a methacrylic acid resin, or a maleimide resin; or a thermoplastic resin. The adhesive may additionally contain a coloring agent, an inorganic filler, various coupling agents, a solvent, and so forth as the case may be.

A preferable mixing ratio of the curing agent including an imidazole ring and the curing type antioxidant is equal to or more than 1wt.% and equal to or less than 20wt.% in total of the both, with respect to the entirety of the adhesive. The content not less than 1wt.% secures sufficient cleaning performance of the metal surface, and provides a sufficient curing effect of the epoxy resin. The content not exceeding 10wt.% suppresses too quick curing reaction, thereby securing sufficient fluidity of the adhesive layer. Also, the epoxy curing agent and the curing type antioxidant may be employed in combination, or either thereof may be independently employed.

Methods of preparing the adhesive include dissolving the resin including the phenolic hydroxyl group (A) of a solid form and the resin (B) serving as a solid curing agent in a solvent, dissolving the resin including the phenolic hydroxyl group (A) of a solid form in the resin (B) of a liquid form serving as the curing agent, dissolving the resin (B) serving as a solid curing agent in the resin including the phenolic hydroxyl group (B) of a liquid form, and dispersing or dissolving the compound (D) including the imidazole ring and serving as the curing agent of the epoxy resin and the curing type antioxidant (E) in a solution in which the epoxy resin (C) of a solid form is dissolved. Examples of the solvent include acetone, methylethylketone, methylisobutylketone, cyclohexane, toluene, butyl cellsolve, ethyl cellosolve, N-methylpyrrolidone, and γ-butyllactone. Preferably, the boiling point of the solvent is equal to or lower than 200°C.

The adhesive with the flux effect is formed by applying the foregoing resin composition to a demoldable base material. Examples of the demoldable base material include a metal foil constituted of copper or a copper-based alloy, aluminum or an aluminum-based alloy; and resin films constituted of a fluorine-based resin, a polyimide resin, and a polyester resin such as a polybutylene terephthalate or a polyethylene terephthalate.

Methods of forming the base material from the foregoing resin composition include applying the resin of a liquid form to the base material, and heating and pressurizing in a vacuum laminator, between which the latter is simpler and provides higher stability in thickness of the interlayer adhesive 136. More specifically, in the process of applying the resin composition to the demoldable base material, normally the resin is employed in a form of varnish. Such arrangement upgrades the application performance.

It is preferable that the solvent employed to prepare the varnish exhibits high solubility for the resin composition, however a poor solvent may be employed as far as a disadvantageous effect is incurred. Examples of the good solvent include dimethylformamide (DMF), methylethylketone (MEK), and cyclohexanone. When preparing the varnish, the solid content of the resin composition is not specifically limited but a preferable range is 20 to 90wt.%, and more preferably 30 to 70wt.%.

Applying the foregoing varnish to the demoldable base material and drying at 80 to 200°C provides the adhesive with the flux effect 136. It is preferable to set the resin thickness after the application and drying so as to be equal to or less than ±20% of the height of the solder bump.

Now, a process of removing the interlayer adhesive 136 between the metal coating layer 137 and the first and the second conductor pad 125, 135 to thereby achieve the electrical connection between the first and the second circuit substrate 111, 112 and the connection substrate 110 will be described.

The first and the second circuit substrate 111, 112 and the connection substrate 110 are mutually positioned in advance. The positioning may be performed by reading a mark provided as the conductor pattern with an image recognition apparatus so as to adjust the position, and utilizing positioning pins. The substrates located in position are pressurized at a predetermined temperature and pressure in vacuum.

A preferable range of the predetermined temperature is equal to or more than 230°C and equal to or less than 280°C, and more preferably equal to or more than 250°C and equal to or less than 270°C. It is preferable to preheat the connection substrate 110 and the first and the second circuit substrate 111, 112 to such predetermined temperature. Setting the temperature to be equal to or higher than the upper limit specified above brings the viscosity of the interlayer adhesive 136 into a range of 10 Pa·S to 400 Pa·S thereby achieving a sufficient softening effect, which enables removing the interlayer adhesive 136 from between the metal coating layer 137 and the first and the second conductor pad 125, 135. In this process, since the tip portion of the projecting portion of the first and the second conductor post 155, 165 is not flat, the interlayer adhesive is guided aside, to be more easily removed.

Also, when the temperature is equal to or less than the foregoing upper limit, the substrate can be prevented from excessively shrinking by heat, and fluctuation in size can be suppressed. Further, since the metal coating layer 137 is melted, pressure concentration to the first and the second conductor post 155, 165 is alleviated, and hence the first and the second circuit substrate 111, 112 can be prevented from being distorted or becoming wavy because of the distortion. Setting the temperature in the foregoing range enables forming a stable metal alloy layer, and formation of the proper fillet leads to stabilized electrical connection between the first and the second circuit substrate 111, 112 and the connection substrate 110.

A preferable range of the predetermined pressure is 0.5 to 3 MPa, and more preferably 1.5 to 2.5 MPa. Setting the pressure at equal to or more than the foregoing lower limit enables sufficiently removing the interlayer adhesive 136 from between the metal coating layer 137 and the first and the second conductor pad 125, 135. When the pressure is equal to or less than the upper limit, the circuit substrate can be prevented from being distorted or becoming wavy because of the distortion. Also the exudation of the interlayer adhesive 136 can be suppressed, so that the interlayer thickness can be prevented from being unstable.

A preferable range of the processing time is equal to or more than one minute and equal to or less than 10 minutes, and more preferably equal to or more than 3 minutes and equal to or less than 8 minutes. Setting the processing time at equal to or more than the foregoing lower limit enables sufficiently removing the interlayer adhesive 136, and promotes the formation of the metal alloy layer. When the processing time is equal to or less than the upper limit, the substrate can be exempted from excessive internal stress.

To properly form the fillet, it is preferable to preheat the connection substrate 110 and other components. The preheating allows preventing the interlayer adhesive 136 from being cured before the temperature reaches the melting point of the metal coating layer 137. Employing a quick-heating apparatus may eliminate the need to preheat, however the apparatus with a larger heat panel is more expensive, and therefore this is difficult from the viewpoint of cost.

Although the first and the second conductor post 155, 165 are projecting from the side of the base material 32 of the connection substrate 110 in this embodiment, the first and the second conductor post 155, 165 may stick out from the side of the coating layer 37 of the connection substrate 110. In other words, the first and the second conductor post 155, 165 may stick out from one or the other side (for example, from the front side and the back side) of the connection substrate. Also, the first and the second conductor post 155, 165 may stick out from the same side or from different sides.

### [Second embodiment]

This embodiment refers to the connection substrate 110 including the first and the second conductor post 155, 165, in which one of the conductor posts is projecting from the side of the base material 32, and the other conductor post is projecting from the side of the coating layer 37. Also, the circuit board manufactured with the connection substrate according to this embodiment will be described.

A circuit substrate including the base material 32, the conductor circuit 31 formed on either side of the base material 32, and the coating layer covering the conductor circuit 31, is prepared. A base material opening is formed on the circuit substrate. To be more detailed, a first hole is formed so as to penetrate through the base material 32 thereby reaching the conductor circuit 31, and a second hole is formed so as to penetrate through the coating layer 37 thereby reaching the conductor circuit 31. As a result, the first conductor post 155 is formed in the first hole so as to stick out from the surface of the base material 32, and the second conductor post 165 is formed in the second hole so as to stick out from the surface of the coating layer 37. Forming the first and the second conductor post 155, 165 in the first and the second hole respectively causes an end portion of the first conductor post 155 and the second conductor post 165 to be connected to the conductor circuit 31 and the other end portion to respectively stick out from the surface of the base material 32 and the coating layer 37. Thus, the connection substrate 110 in which the first and the second conductor post 155, 165 are projecting from different sides can be obtained (Fig. 4).

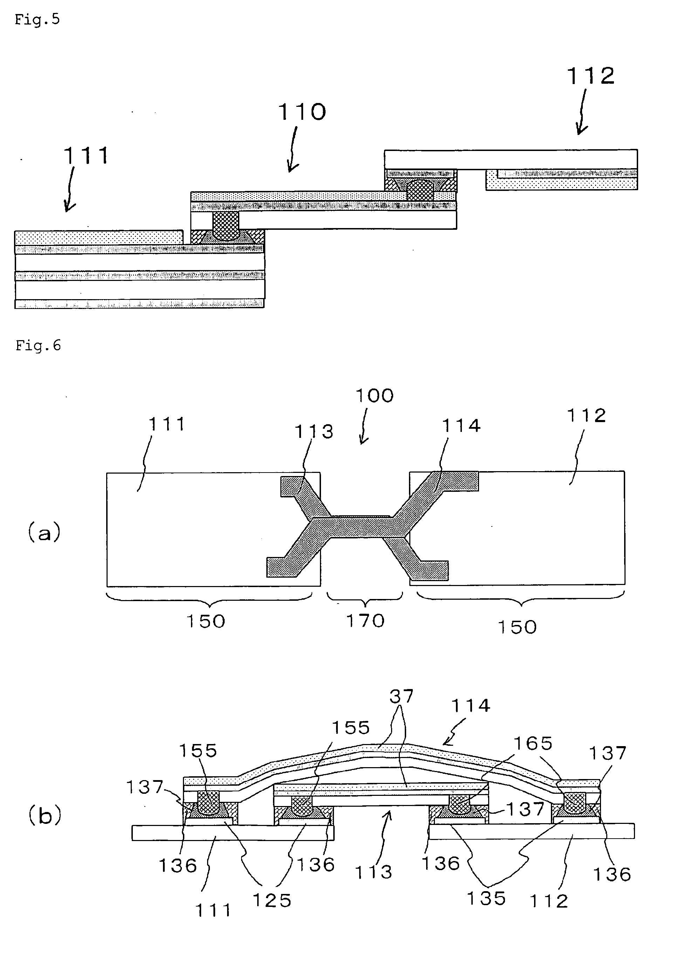

With the connection substrate 110 according to this embodiment, the first and the second circuit substrate 111, 112 can be connected. As shown in Fig. 5, a circuit board is obtained in which an end portion of the connection substrate 110 is connected to a side, for example the upper face, of the first circuit substrate 111, and the other end portion is connected to the other side, for example the lower face, of the second circuit substrate 112. Thus, the end portions of the connection substrate 110 are respectively connected to the opposing sides of the first and the second circuit substrate 111, 112.

### [Third embodiment]

Further, the circuit board 100 including a plurality of connection substrates 113, 114 having a flexible portion will be described in this embodiment. Figs. 6(a) and 6(b) are a plan view and a cross-sectional view respectively, showing the circuit board according to this embodiment. The circuit board 100 includes a region 170 where the respective flexible portions overlap, and in the overlapping region 170 the flexible portions are different in length. Such configuration keeps the flexible portions from being rubbed by each other.

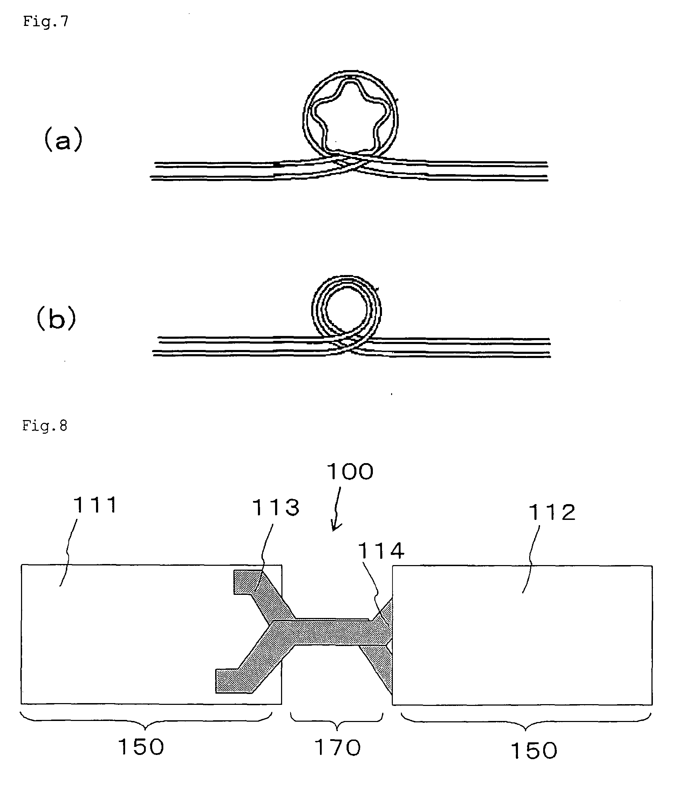

As shown in Fig. 6(b), in the case where an external force is applied to the first and the second circuit substrate 111, 112 so as to move away from each other, one of the connection substrates is strained and the other connection substrate is slacked. It is preferable that, as shown in Fig. 6(a), the slack portion is formed in the overlapping region 170 of the respective flexible portion of the connection substrates 113, 114. For example, the flexible portion of the connection substrate located on the outer side when the connection substrates 113, 114 are helically wound is made longer. Such configuration prevents fracture or corrugation in the helical portion, when the connection substrates 113, 114 are helically wound (Figs. 7(a), 7(b)).

Here, a connection substrate as shown in Fig. 4, in which the first and the second conductor post 155, 165 are projecting from different sides may be employed as the connection substrates 113, 114. In the case of employing such connection substrates 113, 114, a circuit board is obtained in which an end portion of the connection substrates 113, 114 is connected to a side, for example the upper face, of the first circuit substrate 111, and the other end portion is connected to the other side, for example the lower face, of the second circuit substrate 112 (Fig. 8). In other words, the connection substrates 113, 114 are connected to the opposing sides of the first circuit substrate 111 and the second circuit substrate 112.

### [Fourth embodiment]

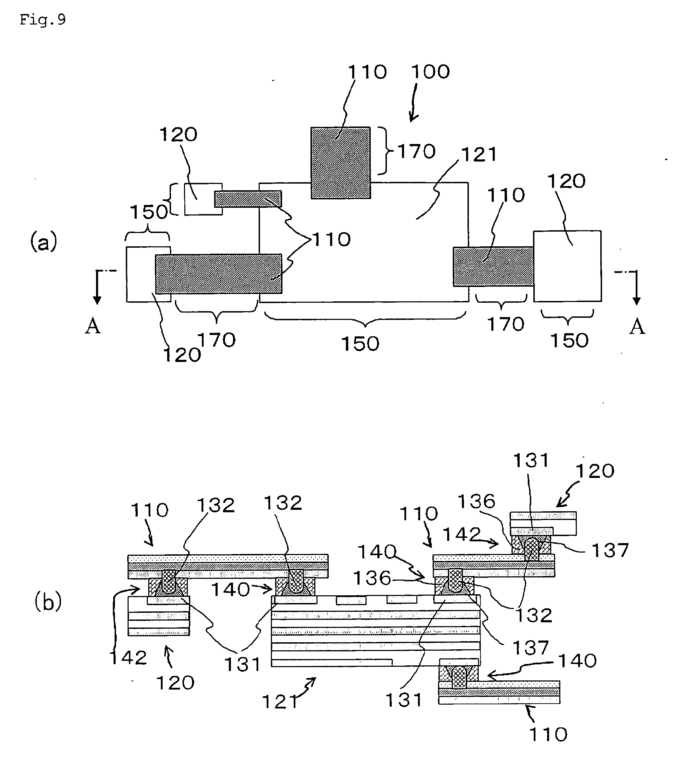

In this embodiment, a circuit board including a primary circuit substrate having a plurality of conductor pads will be described. Fig. 9(a) is a plan view and 9(b) is a cross-sectional view taken along the line A-A in Fig. 9(a), showing a circuit board according to this embodiment. The circuit board 100 includes, as shown in Fig. 9(b), a primary circuit substrate 121 including a plurality of conductor pads 131, and a plurality of connection substrates 110 extending from a peripheral portions of the primary circuit substrate 121. The connection substrate 110 includes a conductor post 132 projecting from one or the other side. The conductor pad 131 and the conductor post 132 are disposed so as to oppose each other at the peripheral portion of the primary circuit substrate 121. The circuit board 100 includes a connector portion 140 to be formed upon melting the metal coating layer 137 formed in advance on at least one of the conductor post 132 or the conductor pad 131, and the primary circuit substrate 121 and the connection substrate 110 are electrically connected through the connector portion 140.

Also, the circuit board 100 may include at least a secondary circuit substrate 120. The secondary circuit substrate 120 is connected to the primary circuit substrate 121 through the connection substrate 110. An end portion of the connection substrate 110 is connected to the periphery of the primary circuit substrate 121, and another conductor post 132 is provided on either side of the other end portion, with its tip portion projecting therefrom. At the position opposing such another conductor post 132, the secondary circuit substrate 120 including a conductor pad 131 is located, and another connector portion 142 is formed upon melting the metal coating layer 137 formed in advance on at least one of the another conductor post 132 and the conductor pad 131. As a result, the circuit board 100 can be obtained in which the secondary circuit substrate 120 and the connection substrate 110 are electrically connected through the another connector portion 142.

Also, as shown in Fig. 9(b), the connector portion 140 may be provided on both sides of the primary circuit substrate 121.

The primary circuit substrate 121 and the secondary circuit substrate 120 are free from specific limitations except for including the conductor pad 131 to be joined with the conductor post 132, and a similar structure to that of the first and the second circuit substrates 111, 112 may be employed.
The primary circuit substrate herein refers to a substrate including a plurality of conductor pads, so as to be connected to a secondary circuit substrate through a plurality of connection substrates. The primary circuit substrate is, for example, a large mother board on which primary functions are implemented. On the other hand, the secondary circuit substrate may be a smaller substrate than the primary circuit substrate, or a sub-board including the same or a fewer number of layers than the primary circuit substrate.

The secondary circuit substrate 120 includes at least a secondary substrate. The secondary substrate herein refers to the individual layers constituting the secondary circuit substrate 120. Such layers include a base material and a conductor circuit, and a similar structure to the foregoing may be employed. The secondary circuit substrate 120 becomes a one-sided secondary circuit substrate when constituted of a secondary substrate; a double-sided secondary circuit substrate when constituted of two secondary substrates; and a multilayer secondary circuit substrate when constituted of a larger number of secondary substrates.
At least one of the secondary circuit substrates 120 included in the circuit board 100 according to this embodiment may be different in number of layers from the primary circuit substrate 121. Providing different number of layers better accomplishes the simplification of the manufacturing process intended by the present invention.

Further, the conductor post 132 and the periphery thereof may be selectively covered with the interlayer adhesive 136, as already stated. In this case, the primary circuit substrate 121, the secondary circuit substrate 120 and the connection substrate 110 are stacked and bonded by means of the interlayer adhesive 136, however in the circuit board 100 finally obtained the interlayer adhesive 136 is no longer present between the metal coating layer 137 and the conductor pad. Such arrangement assures the electrical connection among the primary circuit substrate 121, the secondary circuit substrate 120 and the connection substrate 110.

In this embodiment, for example, the primary circuit substrate 121 and the secondary circuit substrate 120 constitute a rigid portion 150. The connection substrate 110 constitutes the flexible portion 170 extending from the rigid portion 150. Such configuration allows providing a circuit board of a module form, without employing a complicated and integrated rigid-flex circuit board or passing through a complicated manufacturing process.

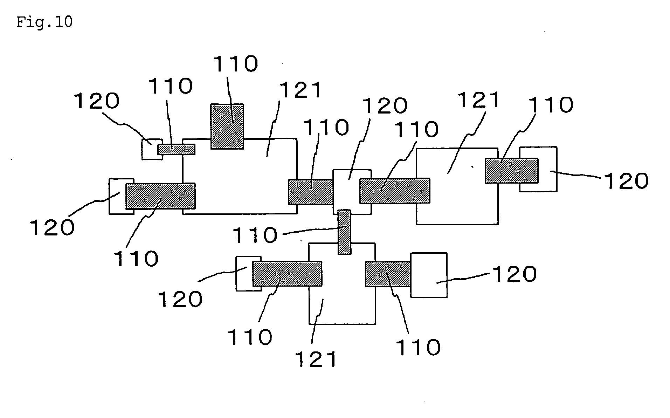

Further, as shown in Fig. 10, in the circuit board according to this embodiment, a plurality of primary circuit substrates 121 may be connected in branches through the connection substrates 110. To the other end portion of the connection substrate 110 extending from the periphery of each of the primary circuit substrates 121, the secondary circuit substrate 120 is connected as the case may be. Thus, connecting a larger number of primary circuit substrates 121 and of the secondary circuit substrates 120 enables providing a circuit board smaller in size and lighter in weight, without complicating the manufacturing process and increasing the number of components to be implemented. The circuit board according to this embodiment may be applied to various small-sized mobile apparatuses.

Although the embodiments of the present invention have been described as above referring to the drawings, it is to be understood that they are merely exemplary and that various other arrangements than the foregoing may be adopted.

## Claims

1. A circuit board comprising a first and a second circuit substrate located with a spacing, on which a first and a second conductor pad are provided respectively; and a connection substrate including a first and a second conductor post projecting from one or the other side;
said connection substrate being disposed so as to cover a portion of said first and said second circuit substrate, and bridged therebetween;
said first conductor post and said first conductor pad, as well as said second conductor post and said second conductor pad, being disposed so as to oppose each other;
said circuit board comprising a connector portion to be formed upon melting a metal coating layer, formed in advance on a surface of at least one of said first conductor post and said first conductor pad, and on a surface of at least one of said second conductor post and said second conductor pad; said first and said second circuit substrate and said connection substrate being electrically connected through said connector portion.

2. The circuit board according to claim 1, wherein an end portion of said connection substrate is connected to a side of said first circuit substrate, and the other end portion is connected to the other side of said second circuit substrate.

3. The circuit board according to claim 1 or 2, comprising a plurality of connection substrates including a flexible portion; and a region where the respective flexible portions overlap; wherein said flexible portions are different in length in said overlapping region.

4. The circuit board according to any of claims 1 to 3, wherein said first circuit substrate and said second circuit substrate are different in number of layers.

5. A circuit board comprising a primary circuit substrate including a plurality of conductor pads; and
a plurality of connection substrates including a conductor post projecting from one or the other side;
said conductor pad and said conductor post being disposed so as to oppose each other at an end portion of said primary circuit substrate;
said circuit board comprising a connector portion to be formed upon melting a metal coating layer formed in advance on a surface of at least one of said conductor post and said conductor pad; said primary circuit substrate and said plurality of connection substrates being electrically connected through said connector portion.

6. The circuit board according to claim 5, further comprising at least a secondary circuit substrate including a conductor pad;
said connection substrate having an end portion connected to a periphery of said primary circuit substrate, and including another conductor post on either side of the other end portion;
said circuit board comprising a connector portion to be formed upon melting a metal coating layer formed in advance on a surface of at least one of said conductor pad and the another conductor post provided on said secondary circuit substrate; said secondary circuit substrate and said connection substrate being electrically connected through said connector portion.

7. The circuit board according to claim 5 or 6, wherein said connector portion is provided on both sides of said primary circuit substrate.

8. The circuit board according to claim 6 or 7, wherein said secondary circuit substrate includes one or more secondary substrates, and at least one of said secondary circuit substrates is different in number of layers from said primary circuit substrate.

9. The circuit board according to any of claims 1 to 8, wherein said connection substrate includes:
a base material, a conductor circuit formed on either side of said base material, and a coating layer that covers said conductor circuit;
a first and a second hole penetrating through at least one of said base material and said coating layer, so as to reach said conductor circuit; and
a first and a second conductor post formed in said first and said second hole respectively; an end portion of said first and said second conductor post being connected to said conductor circuit, and the other end portion of said first and said second conductor post projecting from a surface of said base material or of said coating layer.

10. The circuit board according to any of claims 1 to 4, wherein a periphery of said first and said second conductor post is selectively covered with an interlayer adhesive, and said first and said second circuit substrate and said connection substrate are stacked and adhered by said interlayer adhesive through a metal coating layer.

11. The circuit board according to any of claims 5 to 9, wherein a periphery of said conductor post is selectively covered with an interlayer adhesive, and said primary circuit substrate and said connection substrate are stacked and adhered by said interlayer adhesive through a metal coating layer.

12. The circuit board according to claim 11, wherein said interlayer adhesive is an adhesive having a flux effect.

13. The circuit board according to any of claims 1 to 12, wherein said connector portion constitutes a fillet.

14. The circuit board according to any of claims 1 to 13, wherein said connection substrate is a flexible substrate.

15. The circuit board according to any of claims 1 to 14, wherein a tip portion of a projecting portion of said conductor post includes an unflat portion.

16. A connection substrate comprising:
a base material, a conductor circuit formed on either side of said base material, and a coating layer that covers said conductor circuit;
a first and a second hole penetrating through at least one of said base material and said coating layer, so as to reach said conductor circuit; and
a first and a second conductor post formed in said first and said second hole respectively; an end portion of said first and said second conductor post being connected to said conductor circuit, and the other end portion of said first and said second conductor post projecting from a surface of said base material or of said coating layer.

17. The connection substrate according to claim 16, wherein one of said first and said second conductor post is formed in said hole penetrating through said base material so as to project from said surface of said base material, and the other conductor post is formed in said hole penetrating through said coating layer, so as to project from said surface of said coating layer.

18. The circuit board according to claim 16 or 17, wherein said connection substrate is flexible.

19. The circuit board according to any of claims 16 to 18, wherein a tip portion of a projecting portion of said conductor post includes an unflat portion.

20. The circuit board according to any of claims 16 to 19, wherein said first and said second conductor post is covered with a metal coating layer.
